# EUROPÄISCHE PATENTANMELDUNG

(11) **EP 1 052 545 A2**
(43) Veröffentlichungstag der Anmeldung: **15.11.2000**
(21) Anmeldenummer: 00106363.5
(22) Anmeldetag: 24.03.2000
(51) Int. Cl.: G03F 7/20

(54) **Projektions-Belichtungsanlage und Belichtungsverfahren der Mikrolithographie**

(30) Priorität: 11.05.1999 DE 19921795
(71) Anmelder: Carl Zeiss, 89518 Heidenheim (Brenz) (DE); Carl Zeiss Stiftung Trading as Carl Zeiss, 89518 Heidenheim (DE)
(72) Erfinder: Schuster, Karl-Heinz, 89551 Königsbronn (DE)
(74) Vertreter: Lorenz, Werner, Dr.-Ing.

(57) **Zusammenfassung**

Eine Projektions-Belichtungsanlage mit einer ein Pulslicht erzeugenden Lichtquelle, insbesondere einem ein linear polarisiertes Licht erzeugenden Laser 1, ist mit einem Beleuchtungsstrahlengang, mit einer Beleuchtungseinrichtung 2 und einem Linsensystem 3 als Objektiv versehen. Im Beleuchtungsstrahlengang, vorzugsweise zwischen der Lichtquelle 1 und der Beleuchtungseinrichtung 2 ist ein rotierendes die Polarisation änderndes Element 7 derart angeordnet, daß sich in der Beleuchtungseinrichtung 2 die Pulse in ihrer Polarisationswirkung aufheben.

## Beschreibung

Die Erfindung betrifft eine Projektions-Belichtungsanlage mit einer ein Pulslicht erzeugenden Lichtquelle nach der im Oberbegriff von Anspruch 1 näher definierten Art. Die Erfindung betrifft auch ein Belichtungsverfahren der Mikrolithographie.

Beleuchtungseinrichtungen von Projektions-Belichtungsanlagen, insbesondere Lithographie-Objektive, besitzen in Verbindung mit linear polarisierenden Lichtquellen, wie z.B. Lasern, polarisationsoptische Eigenschaften, die den heutigen Anforderungen nicht mehr in allen Fällen genügen. Häufig wird linear polarisiertes Laserlicht mit einem Polarisationsgrad von ca. 90-95° durch eine Lambda/4-Platte zirkular gemacht. Das Ziel ist es, diesen zirkularen Zustand bis auf einen zu belichtenden Wafer zu erhalten. Nachteilig ist jedoch, daß die optischen Komponenten in dem Beleuchtungssystem, im Objektiv und Reticle-Strukturen Phasendifferenzen einführen. Dies hat zur Folge, daß das ursprüngliche zirkulare Laserlicht einen elliptischen Polarisationszustand bekommt. Der Nachteil davon ist, daß auf diese Weise ein unkontrollierter Zustand entsteht, der wechselnd von Objektiv und Beleuchtung zum jeweils nächsten Paar ist. Die Folgen davon sind ungleichmäßige Helligkeitsverteilungen über das Bildfeld und unkontrollierte Einflüsse auf die Abbildung und die Bildentstehung.

Diese Fehler lassen sich derzeit nur durch deutlich spannungsarme Materialien, polarisationserhaltende Schichten auf Spiegeln, Verzicht auf einen Glasstab und ähnliches reduzieren, was jedoch nur mit einem erheblichen Aufwand möglich ist.

In der US 5 673 103 ist eine Beleuchtungsanlage der Photolithographie beschrieben, wobei eine Anordnung zur Rotation der Polarisationsrichtung mit einer Lambda/2-Platte vorgesehen ist. Um eine Beleuchtung mit linear polarisiertem Licht wechselnder Richtung im Zusammenhang mit einer gesteigerten Auflösung bzw. Tiefenschärfe zu erreichen, wird die Lambda/2-Platte nach einer Fokussierlinse und einem optischen Integrator gedreht.

Der vorliegenden Erfindung liegt die Aufgabe zugrunde, eine Projektions-Belichtungsanlage und ein Belichtungsverfahren der Mikrolithographie zu schaffen, bei welchem die Nachteile des Standes der Technik vermieden werden, insbesondere bei dem sich keine ungleichmäßige Helligkeitsverteilung über dem Bildfeld und unkontrollierte Einflüsse auf die Abbildung und Bildentstehung ergeben.

Erfindungsgemäß wird diese Aufgabe durch die im kennzeichnenden Teil von Anspruch 1 genannten Merkmale gelöst.

Ein erfindungsgemäßes Belichtungsverfahren ist in Anspruch 11 beschrieben.

Durch die erfindungsgemäße Anlage und das Verfahren kann man praktisch die bekannten Systeme ohne aufwendige Änderungen nahezu unverändert belassen und dabei jedoch einen polarisationsoptischen Effekt erzwingen, nämlich den Wafer unpolarisiert zu belichten. Hierzu dient das die Polarisation ändernde Element. Dies kann z.B. auf einfache Weise durch eine Lambda/2-Platte erreicht werden, die zwischen dem Ende der Strahlzufügung des linear polarisierten Lichtes und dem Eingang der Beleuchtungseinrichtung bzw. dem Beleuchtungssystem angeordnet ist.

Bekannterweise dreht eine Lambda/2-Platte die Polarisationsrichtung eines linearen Lichtes. Dreht sich dabei die Lambda/2-Platte mit ihrer Achse, welche in der optischen Achse oder parallel dazu liegt, so dreht das austretende lineare Laserlicht mit seiner Schwingungsrichtung mit dieser doppelten Frequenz. Der einzelne Puls der Lichtquelle, z.B. eines Litholasers, kann nun mit der Drehbewegung der Lambda/2-Platte synchronisiert werden. Von Puls zu Puls dreht sich dabei die Lambda/2-Platte um 45° weiter. Das in das Beleuchtungssystem eintretende Laserlicht bleibt linear und wechselt von Puls zu Puls jeweils um 90°. Hat man eine definierte Lage der Kristallachse zum Puls in der Lambda/2-Platte eingestellt, also 0°, 45°, 90°, 135°, 180°, usw., kann die Polarisation etwa 0° und 90° zu den Spiegelkanten des Beleuchtungssystems erreichen. Das Entscheidende dabei ist: 0° und 90° Polarisation zwischen zwei Pulsen ist nun genau orthogonal. Führt man nun eine Belichtung mit diesen zwei orthogonalen Pulsen durch, der Resist des Wafers integriert, entspricht dies im Belichtungsergebnis in der Summe genau dem von zwei völlig unpolarisierten Pulsen. Dies bedeutet eine Aufhebung des polarisierten Lichtes bzw. nahezu depolarisiertes Licht. Durch die hohe Frequenz bei z.B. Verwendung von Litholasern mit etwa 2000 bis 8000 Hz sind immer genügend Belichtungspaare vorhanden.

Praktisch heben sich die Pulse nach der Lambda/2-Platte in ihrer Polarisationsrichtung auf und zwar paarweise bzw. sie ergänzen sich zu einer unpolarisierten Wirkung.

Beläßt man im Beleuchtungssystem z.B. eine Lambda/4-Platte, bekommt man unter Anwesenheit von Phasenverzögerungen ein Pulspaar mit links- und rechtselliptischem Licht, was zum vollkommen zirkularen Licht in der Belichtung äquivalent ist, was das Ziel der bestehenden Systeme ist.

Polarisationsdrehende Elemente im folgenden Strahlengang stören also die erfindungsgemäße Wirkung nicht. Polarisationsselektierende Elemente werden in ihrer Störwirkung zumindest gemildert.

Der zusätzliche Aufwand im System durch eine sich drehende synchronisierte Lambda/2-Platte ist im Vergleich zu bekannten Einrichtungen zur Vermeidung der geschilderten Nachteile vernachlässigbar.

Ein weiterer Vorteil der Erfindung besteht darin, daß man auch nachträglich bestehende Projektions-Belichtungsanlagen auf diese Weise entpolarisieren kann, womit sich auf kostengünstige Weise neue Anwendungsmöglichkeiten ergeben.

Nachfolgend sind anhand der Zeichnung zwei Ausführungsbeispiele der Erfindung prinzipmäßig beschrieben.

Es zeigt:
- Figur 1: eine Ausführungsform einer Projektions-Belichtungsanlage mit den wesentlichen Bauteilen, und
- Figur 2: eine abgewandelte Ausführungsform der Projektions-Belichtungsanlage nach der Figur 1.

Von einem linearpolarisierte Pulse erzeugenden Laser 1 als Lichtquelle wird Licht im Beleuchtungsstrahlengang einer Beleuchtungseinrichtung 2 zugeführt, der ein Objektiv 3 im Strahlengang nachgeschaltet ist. Auf das Objektiv 3 kann ein Plattenpolarisator 4 folgen, von dem aus dann wieder radial polarisiertes Licht auf einen Wafer 5 gelangt.

Zwischen der Beleuchtungseinrichtung 2 und dem Objektiv 3 ist ein Reticle 6 angeordnet.

Der Beleuchtungsstrahlengang umfaßt vielfach ein Lichtführungssystem mit Umlenkspiegeln, Strahllagestabilisierung usw. und die eigentliche Beleuchtungseinrichtung, welche die Beleuchtung der Reticle 6 mit geeigneter Feldgröße, Apertur, Homogenität, Kohärenzgrad usw. erzeugt.

Im Strahlengang zwischen der Laserlichtquelle 1 und der Beleuchtungseinrichtung 2 ist nun eine Lambda/2-Platte 7 angeordnet, die durch eine nicht dargestellte Einrichtung um ihre Achse gedreht werden kann, wobei die Drehachse der optischen Achse entspricht. Teile der Beleuchtungseinrichtung können auch vor der Lamda/2 Platte angeordnet sein. Die Drehung der Lambda/2-Platte 7 ist dabei gegenüber den Einzelpulsen der Laserlichtquelle 1 synchronisiert, wobei sie sich von Puls zu Puls um 45° weiterdreht. Auf diese Weise erzeugt die Lambda/2-Platte 7 eine orthogonale Polarisation von Puls zu Puls, wobei der nachgeschaltete Plattenpolarisator 4, der in Form einer beschichteten Abschlußplatte ausgebildet ist, eine radiale Polarisation erzeugt (siehe DE P 19535392-7). Die Kombination dieser beiden Bauteile senkt die Probleme mit Beleuchtungsvariationen über dem Bildfeld. Auf diese Weise kann man auch ein bestehendes Objektiv 3 preiswert auf eine radiale Polarisation nachrüsten.

Das System funktioniert auch mit einer nicht polarisationsoptisch neutral arbeitenden Beleuchtungseinrichtung 2.

In der Beleuchtungseinrichtung 2 kann - wie meist üblich - auch eine Lambda/4-Platte 8 integriert bleiben.

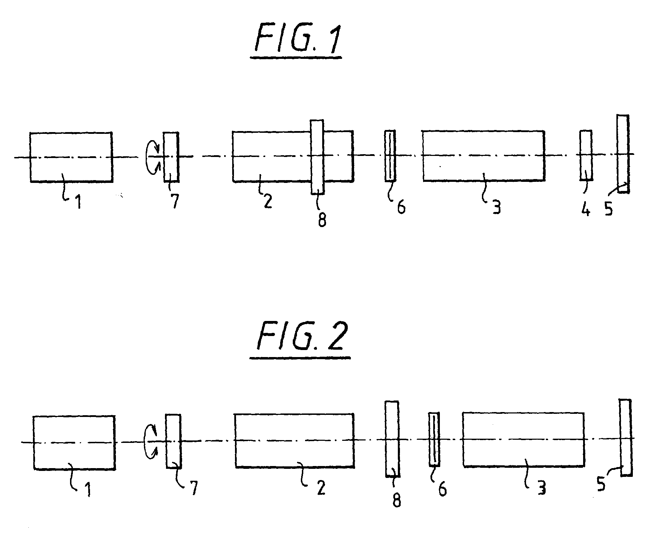

Die sich drehende Lambda/2-Platte 7 kann sehr wirkungsvoll auch in Verbindung mit einem doppelbrechenden Reticle gemäß Ausführungsbeispiel nach der Figur 2 eingesetzt werden. Wie ersichtlich, entspricht das Ausführungsbeispiel nach der Figur 2 im wesentlichen dem Ausführungsbeispiel nach der Figur 1, weshalb für die gleichen Bauteile auch die gleichen Bezugszeichen beibehalten worden sind. Unterschiedlich hierbei ist lediglich, daß eine feststehende Lambda/4-Platte 8, die jedoch für das Verfahren in dieser Form selbst bedeutungslos ist, nach der Beleuchtungseinrichtung 2 angeordnet ist. Darüber hinaus wurde auf den dem Objektiv 3 nachgeschalteten Plattenpolarisator verzichtet.

Auch in diesem Falle wird durch die Lambda/2-Platte 7 wieder zeitlich hintereinander senkrecht bzw. waagrecht polarisiertes Licht erzeugt. Von Puls zu Puls erzeugt die Lambda/2-Platte 7 damit rechts- bzw. linkselliptisches polarisiertes Laserlicht. Als Folge davon wechseln alle Pulse durch das Reticle (Mg F₂-Platte) 6 orthogonal in Folge. Über der Apertur steigt die Phasendifferenz laufend an. In Folge dessen wechseln die Polarisationszustände laufend. Dies bedeutet, der Wafer 5 wird dadurch im Prinzip völlig unpolarisiert beleuchtet. Die Wirkung einer doppelbrechenden Reticle-Platte, z.B. aus Mg F₂ wie für 157 nm Lithographie vorgeschlagen, ist damit bedeutungslos, was den Polarisationszustand betrifft. Für die Abbildung des Glasstabes in der Blendenebene des Objektives 3 ist die eventuelle Doppelbrechung der Reticle-Platte dann ebenfalls bedeutungslos.

Bei Reticles, die in Reflexion eingesetzt werden, hat die Polarisationsmischung gemäß der Erfindung ebenfalls große Vorteile bei der Vermeidung von polarisationsbedingten Störungen.

## Patentansprüche

1. Projektions-Belichtungsanlage mit einer ein Pulslicht erzeugenden Lichtquelle, insbesondere einem ein linearpolarisiertes Licht erzeugenden Laser, einem Beleuchtungsstrahlengang mit einer Beleuchtungseinrichtung mit einem Linsensystem, und mit einem Wafer, dadurch gekennzeichnet, daß im Beleuchtungsstrahlengang, vorzugsweise zwischen der Lichtquelle (1) und der Beleuchtungseinrichtung (2), ein rotierendes, die Polarisation änderndes Element (7) derart angeordnet ist, daß sich in der Beleuchtungseinrichtung (2) die Pulse in ihrer Polarisationswirkung aufheben.

2. Projektions-Belichtungsanlage nach Anspruch 1, dadurch gekennzeichnet, daß zwischen der Lichtquelle (1) und der Beleuchtungseinrichtung (2) eine Lambda/2-Platte (7) als ein die Polarisation änderndes Element angeordnet ist.

3. Projektions-Belichtungsanlage nach Anspruch 2, dadurch gekennzeichnet, daß die Lambda/2-Platte (7) um ihre Achse (optische Achse) während den Einzelpulsen der Lichtquelle (1) drehbar ist.

4. Projektions-Belichtungsanlage nach Anspruch 3, dadurch gekennzeichnet, daß die Drehung der Lambda/2-Platte (7) mit den Einzelpulsen der Lichtquelle (1) synchronisiert ist.

5. Projektions-Belichtungsanlage nach Anspruch 4, dadurch gekennzeichnet, daß die Lambda/2-Platte (7) von Puls zu Puls um 45° drehbar ist.

6. Projektions-Belichtungsanlage nach einem der Ansprüche 1 bis 5, dadurch gekennzeichnet, daß in der Anlage eine Lambda/4-Platte (8) angeordnet ist.

7. Projektions-Belichtungsanlage nach einem der Ansprüche 1 bis 6, dadurch gekennzeichnet, daß dem die Polarisation ändernden Element (7) ein Plattenpolarisator (4) nachgeschaltet ist.

8. Projektions-Belichtungsanlage nach Anspruch 7, dadurch gekennzeichnet, daß der Plattenpolarisator (4) der Beleuchtungseinrichtung nachgeschaltet ist.

9. Projektions-Belichtungsanlage nach Anspruch 7 oder 8, dadurch gekennzeichnet, daß als Plattenpolarisator (4) ein doppelt brechender Reticle vorgesehen ist.

10. Projektions-Belichtungsanlage nach Anspruch 9, dadurch gekennzeichnet, daß der Plattenpolarisator (4) bzw. der Retide als beschichtete Abschlußplatte ausgebildet ist.

11. Belichtungsverfahren der Mikrolithographie mit einer ein Pulslicht erzeugenden Lichtquelle mit einem Beleuchtungssystem, dadurch gekennzeichnet, daß für jede Belichtung eine zeitliche Überlagerung von Licht mit verschiedenem Polarisationszustand erfolgt.
